# EUROPEAN PATENT APPLICATION

(11) **EP 4 618 345 A1**
(43) Date of publication of application: **17.09.2025**
(21) Application number: 22964710.2
(22) Date of filing: 08.11.2022
(51) Int. Cl.: H02H 7/12

(54) **PROTECTION METHOD FOR POWER CONVERSION CIRCUIT, POWER CONVERSION APPARATUS, AND STORAGE MEDIUM**

(71) Applicant: EcoFlow Inc., Shenzhen, Guangdong 518000 (CN)
(72) Inventor: WU, Dong, Shenzhen, Guangdong 518000 (CN); CHEN, Zhenlong, Shenzhen, Guangdong 518000 (CN); CHEN, Xi, Shenzhen, Guangdong 518000 (CN); WANG, Lei, Shenzhen, Guangdong 518000 (CN)
(74) Representative: Appelt, Christian W.
(86) International application number: PCT/CN2022/130499
(87) International publication number: WO 2024/098233

(57) **Abstract**

A protection method for a power conversion circuit is provided, including: calculating an attenuation amount of conversion efficiency of the power conversion circuit within a preset duration when the power conversion circuit is in a steady state; monitoring the attenuation amount based on a preset attenuation threshold, and obtaining a duration for which the attenuation amount is greater than the preset attenuation threshold; and performing a preset protection operation when the duration is greater than a preset protection duration.

## Description

### TECHNICAL FIELD

This application relates to the field of circuit protection technologies, and in particular, to a protection method for a power conversion circuit, a power conversion apparatus, and a storage medium.

### BACKGROUND

Statements herein merely provide background information related to this application, and do not necessarily constitute exemplary technologies.

A power conversion circuit usually refers to a circuit for mutual conversion between alternating current (AC) and AC, AC and direct current (DC), or DC and DC. Energy conversion efficiency of the power conversion circuit usually cannot reach 100%, and lost energy will be converted into heat of a power device. In the case of poor heat dissipation or device aging, heat accumulation will occur. When a temperature of the power device in the power conversion circuit exceeds a maximum operating temperature, the power device may be damaged, resulting in a failure of the power conversion circuit.

In a related technology, a temperature of a device is usually sampled through a temperature sensor or a temperature sampling circuit, and a protection action is performed when the temperature exceeds a safe operating temperature. However, because a high-power conversion circuit usually has a plurality of power devices, the temperature of the power device is sampled through the temperature sensor or the temperature sampling circuit, which may increase manufacturing costs and complexity of the circuit and reduce stability of the circuit.

### SUMMARY

According to various embodiments of this application, a protection method for a power conversion circuit, a power conversion apparatus, and a storage medium are provided.

According to a first aspect, this application provides a protection method for a power conversion circuit. The protection method for a power conversion circuit includes the following steps:
calculating an attenuation amount of conversion efficiency of the power conversion circuit within a preset duration when the power conversion circuit is in a steady state;
monitoring the attenuation amount based on a preset attenuation threshold, and obtaining a duration for which the attenuation amount is greater than the preset attenuation threshold; and
performing a preset protection operation when the duration is greater than a preset protection duration.

According to a second aspect, this application further provides a power conversion apparatus. The power conversion apparatus includes a power conversion circuit and a controller. The controller is configured to implement the steps of the protection method for a power conversion circuit as described above.

According to a third aspect, this application further provides a computer-readable storage medium. The computer-readable storage medium stores a computer program. The computer program, when executed by a processor, causes the processor to implement the steps of the protection method for a power conversion circuit as described above.

Details of one or more embodiments of this application are provided in the accompanying drawings and descriptions below. Other features, objectives, and advantages of this application become apparent from the specification, the accompanying drawings, and the claims.

### BRIEF DESCRIPTION OF THE DRAWINGS

To describe technical solutions of embodiments of this application more clearly, the following briefly describes the accompanying drawings required for describing the embodiments. Apparently, the accompanying drawings in the following description are some embodiments of this application, and a person of ordinary skill in the art may still derive other accompanying drawings from these accompanying drawings without creative efforts.
FIG. 1 is a schematic flowchart of a protection method for a power conversion circuit according to an embodiment of this application.
FIG. 2 is a schematic flowchart of a method for determining a steady state of a power conversion circuit according to an embodiment of this application.
FIG. 3 is a schematic flowchart of another protection method for a power conversion circuit according to an embodiment of this application.
FIG. 4 is a schematic block diagram of a power conversion apparatus according to an embodiment of this application.
FIG. 5 is a schematic structural block diagram of an electronic device according to an embodiment of this application.

The implementation of the objectives, functional characteristics, and advantages of this application are to be further described with reference to the accompanying drawings through the embodiments.

### DETAILED DESCRIPTION

The technical solutions in embodiments of this application are clearly and completely described below with reference to the accompanying drawings in the embodiments of this application. Apparently, the described embodiments are some rather than all of the embodiments of this application. All other embodiments obtained by a person of ordinary skill in the art based on the embodiments of this application without creative efforts shall fall within the protection scope of this application.

The flowcharts shown in the accompanying drawings are merely exemplary descriptions, and do not necessarily include all content and operations/steps, nor do they have to be executed in the described order. For example, some operations/steps may further be broken down, merged, or partially merged. Therefore, an actual execution order may change based on an actual situation.

Some implementations of this application are described in detail below with reference to the accompanying drawings. The following embodiments and features in the embodiments may be combined with each other in the case of no conflict.

The embodiments of this application provide a protection method for a power conversion circuit, a power conversion apparatus, and a computer-readable storage medium. According to the method provided in this embodiment of this application, a temperature change of the power conversion circuit may be indirectly monitored by monitoring an attenuation amount of power under a steady-state condition. When it is detected that the power attenuation amount is greater than a preset attenuation threshold and a duration is greater than a preset protection duration, it may be determined that the power conversion circuit is in a continuous high-temperature state, thereby triggering a preset protection action to stop circuit operation in time, perform heat dissipation, and avoid damage to the power conversion circuit. According to the foregoing method, on the premise of performing temperature protection on the power conversion circuit, circuit stability and increasing circuit complexity may be prevented from being affected due to addition of an additional element, and costs are reduced.

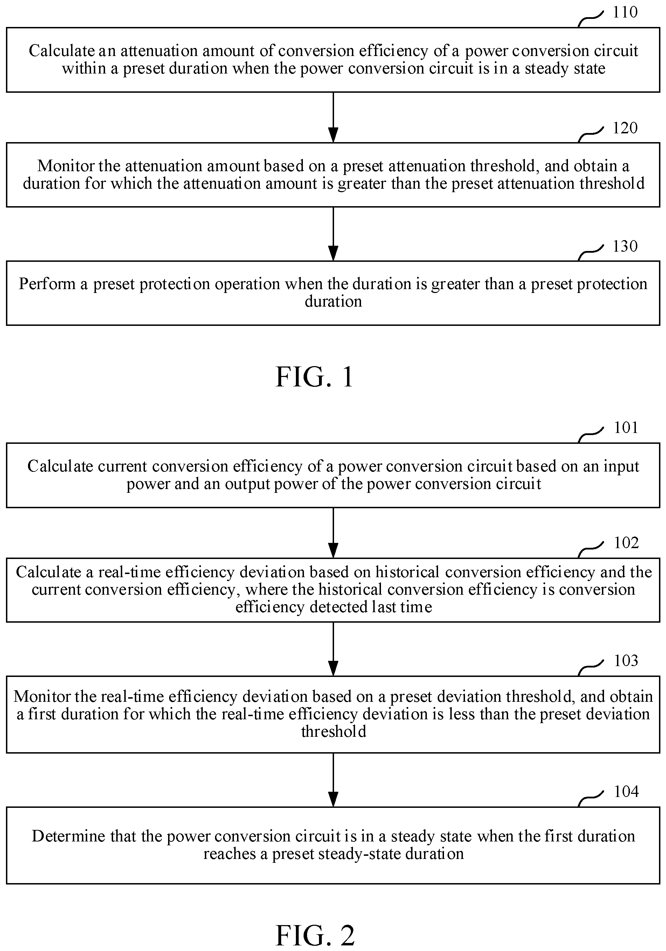

Refer to FIG. 1. FIG. 1 is a schematic flowchart of a protection method for a power conversion circuit according to an embodiment of this application.

As shown in FIG. 1, the protection method for a power conversion circuit includes step S110 to step S130.

Step S110: Calculate an attenuation amount of conversion efficiency of a power conversion circuit within a preset duration when the power conversion circuit is in a steady state.

It may be understood that the power conversion circuit may include an AC/DC circuit, a DC/DC circuit, or a combination of the above. The AC/DC circuit may be an AC-to-DC rectifier circuit, or may be a DC-to-AC inverter circuit. The DC/DC circuit may include an LLC circuit, a buck circuit, a boost circuit, a buck-boost circuit, or any one or a combination of more than one of the above.

It may be understood that the power conversion circuit being in a steady state means that the power conversion circuit is in a stable operating condition. Exemplarily, the power conversion circuit is in an operating condition of stable boost, buck, rectification, or inversion. The conversion efficiency of the power conversion circuit may be different under different operating conditions, but during stable operation under the same operating condition, the conversion efficiency generally remains stable.

In an embodiment, a difference between current conversion efficiency of the power conversion circuit and conversion efficiency before the preset duration is calculated, so that the attenuation amount of the conversion efficiency within the preset duration may be obtained.

In this embodiment, when the power conversion circuit is in a steady state, the attenuation amount of the conversion efficiency of the power conversion circuit is approximately linearly correlated with a runtime. Therefore, it may be indirectly monitored, by monitoring the attenuation amount of the conversion efficiency when the power conversion circuit is in the steady state, whether the power conversion circuit operates normally.

In an embodiment, during operation of the power conversion circuit, factors affecting the conversion efficiency generally include heat accumulation, a current change, a voltage change, and the like. The current change and the voltage change generally lead to a sudden change in the conversion efficiency, and the heat accumulation leads to a continuous decrease in the conversion efficiency.

In an embodiment, the power conversion circuit may be tested to detect a temperature, real-time conversion efficiency, and an attenuation amount of the power conversion circuit in advance, to obtain a parameter change rule of the power conversion circuit in different states, for example, a relationship between the real-time conversion efficiency and time, and a change trend of the attenuation amount and the temperature when the power conversion circuit is in an unsteady state; and in the steady state, impact of a temperature change on the real-time conversion efficiency and the attenuation amount, thereby establishing a correspondence between the temperature and the attenuation amount, facilitating temperature monitoring of the power conversion circuit by monitoring the attenuation amount of the real-time conversion efficiency, and further implementing protection of the power conversion circuit.

In an embodiment, the efficiency of the power conversion circuit has a small fluctuation in a stable operating condition (that is, the steady state), and when a temperature anomaly occurs due to heat accumulation, the efficiency decreases as the temperature rises. Therefore, when the power conversion circuit is in the steady state, monitoring and protection of a circuit state may be implemented by monitoring the conversion efficiency of the power conversion circuit.

Step S120: Monitor the attenuation amount based on a preset attenuation threshold, and obtain a duration for which the attenuation amount is greater than the preset attenuation threshold.

In this embodiment, a preset attenuation threshold of the power conversion circuit in the steady state may be set, an attenuation amount of the efficiency of the power conversion circuit in the steady state within the preset duration is sampled, and then the attenuation amount is compared with the attenuation threshold to determine a current state of the power conversion circuit.

It may be understood that as the runtime goes by, the temperature of the power conversion circuit continues to accumulate and increase, which affects the conversion efficiency of the power conversion circuit. When the temperature of the power conversion circuit accumulates to a certain temperature value, instability of the power conversion circuit is caused, that is, a steady state of the power conversion circuit is destroyed.

When the power attenuation amount is greater than the preset attenuation threshold, it may be determined that the temperature of the power conversion circuit at this time may have accumulatively reached a certain high level. In this case, the operation of the power conversion circuit may need to be stopped in time, to avoid damaging the circuit due to a high temperature.

A factor causing the efficiency conversion change of the power conversion circuit may be temperature accumulation or change, or may be sudden change of a voltage, a current, or the like, or other influencing factors. To avoid affecting the operating efficiency and reliability of the circuit as a result of stopping the operation of the power conversion circuit due to erroneous determination, it may be determined, by monitoring the duration for which the attenuation amount is greater than the preset attenuation threshold, whether efficiency attenuation of the circuit is caused by the temperature factor, to avoid erroneous determination as a result of the sudden change caused by factors such as the voltage and the current.

Step S130: Perform a preset protection operation when the duration is greater than a preset protection duration.

In this embodiment, when it is detected that the power attenuation amount is greater than the preset attenuation threshold, timing is started, and a duration for which the power attenuation amount remains greater than the preset attenuation threshold is recorded.

When the duration is greater than the preset protection duration, it may be determined that a factor causing a reduction in the conversion efficiency of the power conversion circuit at this time is temperature, that is, it is considered that an accumulated temperature of the power conversion circuit at this time reaches a critical point for circuit protection. In this case, the preset protection operation is triggered, and the operation of the power conversion circuit is stopped, to prevent the power conversion circuit from being damaged due to an excessively high temperature.

In an embodiment, when a duration for which the power conversion circuit is in the steady state is less than a target duration threshold, the preset protection duration is the duration for which the power conversion circuit is in the steady state; and when the duration for which the power conversion circuit is in the steady state is greater than or equal to the target duration threshold, the preset protection duration is the target duration threshold.

In an embodiment, different preset protection durations may be set based on different circuit structures and power devices. Exemplarily, the target duration threshold may be based on an average duration for which the power conversion circuit of the same type is maintained in the steady state.

In an embodiment, every time the power conversion circuit enters the steady state, the duration for which the power conversion circuit is maintained in the steady state may be accumulatively recorded, that is, the preset duration, and the foregoing average duration is updated based on the preset duration. When the newly recorded average duration changes greatly, for example, a change of the average duration exceeds 20%, the target duration threshold is adaptively adjusted.

This embodiment provides a protection method for a power conversion circuit. The foregoing method includes: calculating an attenuation amount of conversion efficiency of the power conversion circuit within a preset duration when the power conversion circuit is in a steady state; continuously monitoring the attenuation amount based on a preset attenuation threshold, and obtaining a duration for which the attenuation amount is greater than the preset attenuation threshold; and performing a preset protection operation when the duration is greater than a preset protection duration. When the power conversion circuit is in the steady state, if heat accumulation occurs in the power conversion circuit, efficiency of the power conversion circuit decreases faster. Therefore, a temperature change of the power conversion circuit may be indirectly monitored by monitoring an attenuation amount of power under a steady-state condition. When it is detected that the power attenuation amount is greater than a preset attenuation threshold and a duration is greater than a preset protection duration, it may be determined that the power conversion circuit is in a continuous high-temperature state, thereby triggering a preset protection action to stop circuit operation in time, perform heat dissipation, and avoid damage to the power conversion circuit. According to the foregoing method, on the premise of performing temperature protection on the power conversion circuit, circuit stability and increasing circuit complexity may be prevented from being affected due to addition of an additional element, and costs are reduced.

Refer to FIG. 2. FIG. 2 is a schematic flowchart of a method for determining a steady state of a power conversion circuit according to an embodiment of this application.

As shown in FIG. 2, the method for determining a steady state of a power conversion circuit includes step S101 to step S104.

S101: Calculate current conversion efficiency of the power conversion circuit based on an input power and an output power of the power conversion circuit.

In this embodiment, the conversion efficiency refers to efficiency of the power conversion circuit during power conversion, and is determined by the input power and the output power. Therefore, for the calculation of the conversion efficiency, the input power and the output power of the power conversion circuit may be continuously sampled, and a ratio of the output power to the input power at each moment may be calculated to obtain conversion efficiency at each moment, that is, real-time conversion efficiency.

S102: Calculate a real-time efficiency deviation based on historical conversion efficiency and the current conversion efficiency, where the historical conversion efficiency is conversion efficiency detected last time.

S103: Monitor the real-time efficiency deviation based on a preset deviation threshold, and obtain a first duration for which the real-time efficiency deviation is less than the preset deviation threshold.

S104: Determine that the power conversion circuit is in the steady state when the first duration reaches a preset steady-state duration.

The conversion efficiency at different moments is calculated, and conversion efficiency calculated each time is compared with conversion efficiency calculated last time, that is, compared with the historical conversion efficiency, to monitor a fluctuation range of the conversion efficiency and determine whether the power conversion circuit enters the steady state.

In an embodiment, when the real-time efficiency deviation between the current conversion efficiency and the historical conversion efficiency is less than the preset deviation threshold, timing is started, and a duration for which the real-time efficiency deviation is less than the preset deviation threshold is recorded, that is, the first duration. When the first duration reaches the preset steady-state duration, it may be determined that the power conversion circuit enters the steady state.

It may be understood that, the duration for which the real-time efficiency deviation is continuously less than the preset deviation threshold is monitored herein. If the real-time efficiency deviation is continuously less than the preset deviation threshold, it indicates that current fluctuation of the circuit is extremely small. If the real-time efficiency deviation cannot remain continuously less than the preset deviation threshold, it indicates that the circuit is still in a state of fluctuation and has not entered a steady state. Therefore, erroneous determination of the power conversion circuit that does not enter the steady state as entering the steady state may be avoided, which leads to subsequent inaccurate monitoring of the attenuation amount and false protection.

In an embodiment, step S103 specifically includes:
monitoring the real-time efficiency deviation;
accumulating the first duration if it is monitored that the real-time efficiency deviation is less than the preset deviation threshold; and
resetting the first duration if it is monitored that the real-time efficiency deviation is greater than or equal to the preset deviation threshold.

In this embodiment, when the power conversion circuit is about to enter the steady state, the real-time efficiency deviation thereof may jump back and forth. To ensure that the power conversion circuit is maintained in the steady state, the duration for which the real-time efficiency deviation is less than the preset deviation threshold needs to be accumulated when the real-time efficiency deviation is monitored.

In an embodiment, when the real-time efficiency deviation is continuously less than the preset deviation threshold, the continuous duration, that is, the first duration, is accumulated until the first duration reaches the preset steady-state duration, and it is determined that the power conversion circuit enters the steady state.

In an embodiment, it is determined that the power conversion circuit is in an unsteady state when the first duration does not reach the preset steady-state duration.

In an embodiment, when the first duration starts to be accumulated but does not reach the preset steady-state duration, and the real-time efficiency deviation is greater than the preset deviation threshold, to avoid erroneous determination of the steady state, it is considered that the circuit is in an unsteady state at this time. The accumulated duration of the first duration is cleared, and the accumulation of the first duration is restarted when it is detected next time that the real-time efficiency deviation is less than the preset deviation threshold.

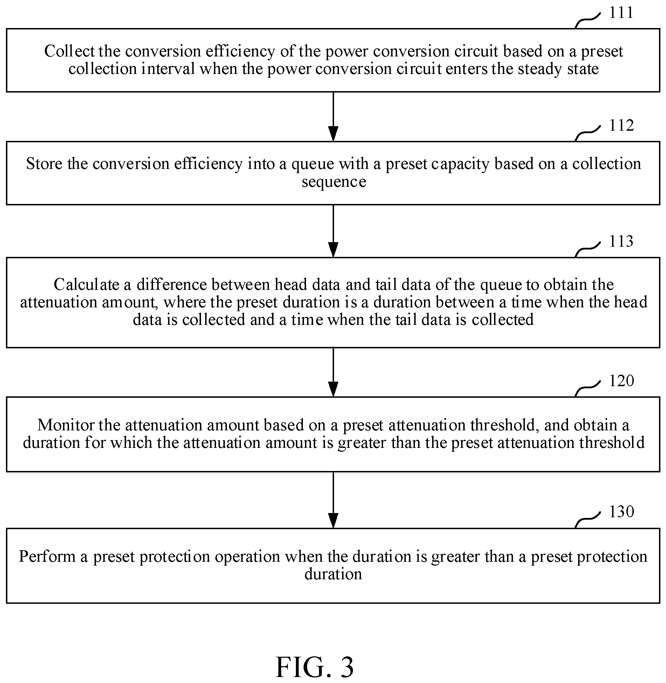

Refer to FIG. 3. FIG. 3 is a schematic flowchart of another protection method for a power conversion circuit according to an embodiment of this application.

As shown in FIG. 3, based on the foregoing embodiment shown in FIG. 1, in this embodiment, step S110 specifically includes the following steps.

Step S111: Collect the conversion efficiency of the power conversion circuit based on a preset collection interval when the power conversion circuit enters the steady state.

In this embodiment, after the power conversion circuit enters the steady state, the real-time conversion efficiency of the power conversion circuit is stably collected based on the preset collection interval.

Step S112: Store the conversion efficiency into a queue with a preset capacity based on a collection sequence.

In an embodiment, when the power conversion circuit enters the steady state, a queue with a capacity of n is created, and currently collected real-time conversion efficiency is stored into the queue in sequence based on a preset collection interval and a collection sequence, until the queue is full. It may be understood that the preset capacity may be set based on a preset duration and the preset collection interval.

Step S113: Calculate a difference between head data and tail data of the queue to obtain the attenuation amount.

In an embodiment, when the queue is not full, first real-time conversion efficiency collected when the power conversion circuit enters the steady state is used as an attenuation reference value of subsequently collected real-time conversion efficiency, and a difference between the currently collected real-time conversion efficiency and the attenuation reference value is used as an attenuation value corresponding to the currently collected real-time conversion efficiency.

It may be understood that the preset duration is a duration between a time when the head data is collected and a time when the tail data is collected. Before the queue is full, the preset duration is a total collection interval between the current tail data and the head data, and the preset duration is a variable value. After the queue is full, the preset duration is a fixed value, that is, a product of a length of the queue and the preset collection interval.

For example, the preset collection interval is 1 s, that is, the real-time conversion efficiency of the power conversion circuit is collected once every 1 s. The preset capacity of the queue may be set to 6, that is, the queue may store 6 values of the real-time conversion efficiency at the same time. When the capacity of the queue is full, that is, when 6 values of the real-time conversion efficiency already exist in the queue, and when the real-time conversion efficiency is collected again, head data of the queue at this time is fetched and used as a reference value of the real-time conversion efficiency, and the real-time conversion efficiency is added to a tail of the queue as tail data of the queue. In this case, a time interval between the head data and the tail data is 6 s, that is, the preset duration is 6 s.

In an embodiment, a dequeuing operation is performed on the head data of the queue when the queue is full, and currently collected conversion efficiency is stored in the queue as the tail data. The currently collected conversion efficiency is stored in the queue as the tail data when the queue is not full.

In an embodiment, the capacity of the queue remains unchanged. When the queue is full, if the real-time conversion efficiency is collected again, head data of the queue is fetched and used as the attenuation reference value of the currently collected real-time conversion efficiency, and the currently collected real-time conversion efficiency is stored into the tail of the queue, so that the queue is maintained in a full state. In this case, attenuation reference values corresponding to the subsequently collected real-time conversion efficiency are all head data of the current queue, that is, time intervals are consistent, thereby ensuring stability and reliability of calculation of the attenuation value.

It may be understood that in addition to a manner of the queue, the attenuation amount within the preset duration may also be calculated in another manner, which is not limited in the implementation of this application. For example, the attenuation amount within the preset duration may also be calculated directly by recording a collection moment. For example, in a steady state, conversion efficiency e1 is collected at a moment t1, and conversion efficiency e2 is collected at a moment t1+T. T is preset duration, and an attenuation amount △e = e2 - e1 within the preset duration may be directly calculated.

How to calculate the attenuation amount of the conversion efficiency of the power conversion circuit within the preset duration is described below by using a queue manner as an example.
1. It is assumed that the power conversion circuit starts to enter a steady state at a t₁ moment.
2. A capacity of a queue for storing data is n, and real-time conversion efficiency e₁ of the power conversion circuit starts at the t₁ moment until the queue is full at a tₙ moment. At tₙ₊₁, real-time conversion efficiency eₙ₊₁ at tₙ₊₁ is enqueued, and e₁ is dequeued. In this case, the front of the queue, that is, the queue head, is e₂, and so on.
3. A current moment is defined as tₓ, and before tₙ₊₁, the queue is not full, and the preset duration corresponding to the attenuation amount is calculated as tₓ - t1, where a reference value e of the conversion efficiency is equal to e₁.
4. After tₙ₊₁, the queue is full, and the preset duration corresponding to the attenuation amount calculated as Δt*n, where Δt is a sampling interval, that is, (tₙ₊₁ - tₙ). In this case, the reference value of the conversion efficiency is the head data, that is: e = eₓ₋ₙ₊₁.
5. The attenuation amount within the preset duration is equal to a conversion efficiency reference value minus a current conversion efficiency, that is: △e = e - eₓ.

It may be understood that when the conversion efficiency is stored in a queue manner, every time the attenuation amount is calculated, the attenuation amount may be obtained by directly fetching the head data and the tail data to calculate a difference therebetween, without the need for timing, thereby simplifying the calculation manner.

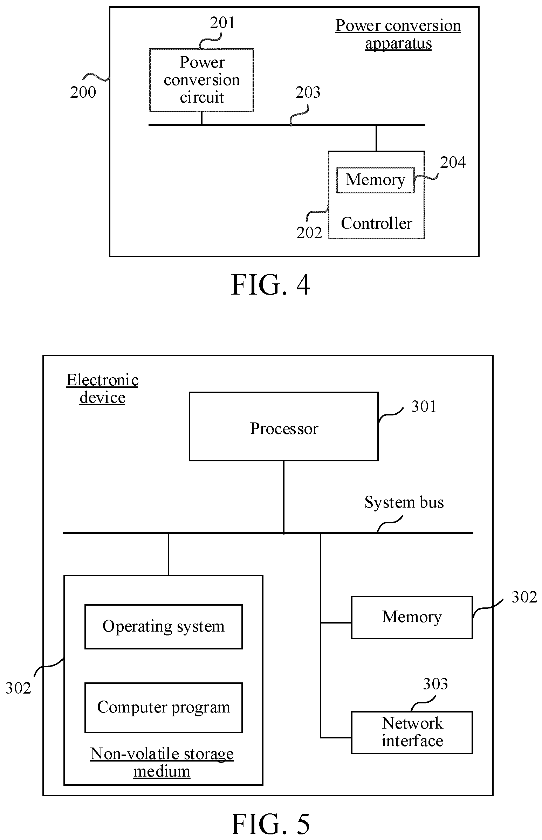

Refer to FIG. 4. FIG. 4 is a schematic block diagram of a power conversion apparatus according to an embodiment of this application. The power conversion apparatus 200 includes one or more power conversion circuits 201 and one or more controllers 202. The one or more controllers 202 independently or jointly operate to implement the steps of the protection method for a power conversion circuit.

Exemplarily, the power conversion circuit 201 and the controller 202 may be connected through a bus 203.

Exemplarily, the controller 202 may be a microcontroller unit (MCU), a central processing unit (CPU), a digital signal processor (DSP), or the like.

Exemplarily, the controller 202 may include a memory 203 that may store a computer-readable storage medium. The memory 204 may be a flash chip, a read-only memory (ROM) disk, an optical disc, a USB flash drive, a mobile hard disk, or the like.

The controller 202 is configured to run a computer program stored in the memory 204, and implement the steps of the foregoing protection method for a power conversion circuit when executing the computer program.

Exemplarily, the controller 202 is configured to run the computer program stored in the memory 204, and implement the following steps when executing the computer program:
calculating an attenuation amount of conversion efficiency of the power conversion circuit within a preset duration when the power conversion circuit is in a steady state;
monitoring the attenuation amount based on a preset attenuation threshold, and obtaining a duration for which the attenuation amount is greater than the preset attenuation threshold; and
performing a preset protection operation when the duration is greater than a preset protection duration.

It should be noted that it may be clearly understood by a person skilled in the art that, for the purpose of convenient and brief description, for a detailed operating process of the foregoing apparatus and modules, reference may be made to the corresponding process in the foregoing embodiments of the protection method for a power conversion circuit. Details are not described herein again.

It may be understood that the foregoing power conversion apparatus may be an independent power conversion device, for example, an inverter or a buck-boost converter, or may be built in another device to implement a power conversion function.

Refer to FIG. 5. FIG. 5 is a schematic structural block diagram of an electronic device according to an embodiment of this application. The electronic device may be a terminal using a power conversion circuit.

Exemplarily, the electronic device may be an energy storage device with a power conversion function, a power converter, a power management device, an intelligent power supply panel, or the like.

Exemplarily, the electronic device may be an autonomous mobile device with a built-in power conversion circuit, and the autonomous mobile device may be a device with an autonomous movement assistance function. The autonomous movement assistance function may be implemented by an on-board terminal, and a corresponding autonomous mobile device may be a vehicle having the on-board terminal. The autonomous mobile device may further be a semi-autonomous mobile device or a completely autonomous mobile device. Exemplarily, the autonomous mobile device may be a lawn mower, a sweeper, a robot having a navigation function, or the like.

Referring to FIG. 5, the electronic device includes a processor 301, a memory 302, and a network interface 303 that are connected through a system bus. The memory 302 may include a non-volatile storage medium.

The non-volatile storage medium may store an operating system and a computer program. The computer program includes a program instruction. When the program instruction is executed, the processor 301 may be caused to perform any protection method for a power conversion circuit.

The processor 301 is configured to provide computing and control capabilities to support operation of the entire electronic device.

An internal memory provides an environment for operation of the computer program in the non-volatile storage medium. When the computer program is executed by the processor 301, the processor 301 may be caused to perform any protection method for a power conversion circuit.

The network interface 303 is configured to perform network communication, for example, send an assigned task. A person skilled in the art may understand that the structure shown in FIG. 5 is merely a block diagram of a partial structure related to the solution of this application, and does not constitute a limitation on the electronic device to which the solution of this application is applied. Specifically, the electronic device may include more or fewer components than those shown in the figure, or some merged components, or different component arrangements.

It should be understood that the processor 301 may be a CPU, and the processor 301 may further be another general-purpose processor, a DSP, an application specific integrated circuit (ASIC), a field-programmable gate array (FPGA) or another programmable logic device, a discrete gate or a transistor logic device, a discrete hardware component, or the like. The general-purpose processor may be a microprocessor, the processor may also be any conventional processor, or the like.

In an embodiment, the processor 301 is configured to run a computer program stored in the memory to implement the following steps:
calculating an attenuation amount of conversion efficiency of the power conversion circuit within a preset duration when the power conversion circuit is in a steady state;
monitoring the attenuation amount based on a preset attenuation threshold, and obtaining a duration for which the attenuation amount is greater than the preset attenuation threshold; and
performing a preset protection operation when the duration is greater than a preset protection duration.

In an embodiment, before implementation of calculating the attenuation amount of the conversion efficiency of the power conversion circuit within the preset duration when the power conversion circuit is in the steady state, the processor 301 is further configured to implement steps of:
calculating current conversion efficiency of the power conversion circuit based on an input power and an output power of the power conversion circuit;
calculating a real-time efficiency deviation based on historical conversion efficiency and the current conversion efficiency, where the historical conversion efficiency is conversion efficiency detected last time;
monitoring the real-time efficiency deviation based on a preset deviation threshold, and obtaining a first duration for which the real-time efficiency deviation is less than the preset deviation threshold; and
determining that the power conversion circuit is in the steady state when the first duration reaches a preset steady-state duration.

In an embodiment, during implementation of monitoring the real-time efficiency deviation based on the preset deviation threshold, and obtaining the first duration for which the real-time efficiency deviation is less than the preset deviation threshold, the processor 301 is configured to implement steps of:
monitoring the real-time efficiency deviation;
accumulating the first duration if it is monitored that the real-time efficiency deviation is less than the preset deviation threshold; and
resetting the first duration if it is monitored that the real-time efficiency deviation is greater than or equal to the preset deviation threshold.

In an embodiment, after implementation of obtaining the first duration for which the real-time efficiency deviation is less than the preset deviation threshold, the processor 301 is further configured to implement a step of:
determining that the power conversion circuit is in an unsteady state when the first duration does not reach a preset steady-state duration.

In an embodiment, during the implementation of calculating the attenuation amount of the conversion efficiency of the power conversion circuit within the preset duration when the power conversion circuit is in the steady state, the processor 301 is configured to implement a step of:
calculating a difference between current conversion efficiency of the power conversion circuit and conversion efficiency before the preset duration, to obtain the attenuation amount.

In an embodiment, the processor 301 is configured to run the computer program stored in the memory, and is further configured to implement that when a duration for which the power conversion circuit is in the steady state is less than a target duration threshold, the preset duration is the duration for which the power conversion circuit is in the steady state; and
when the duration for which the power conversion circuit is in the steady state is greater than or equal to the target duration threshold, the preset duration is the target duration threshold.

In an embodiment, during the implementation of calculating the attenuation amount of the power conversion efficiency of the power conversion circuit within the preset duration when the power conversion circuit is in the steady state, the processor 301 is configured to implement steps of:
collecting the conversion efficiency of the power conversion circuit based on a preset collection interval when the power conversion circuit enters the steady state;
storing the conversion efficiency into a queue with a preset capacity based on a collection sequence; and
calculating a difference between head data and tail data of the queue to obtain the attenuation amount, where the preset duration is a duration between a time when the head data is collected and a time when the tail data is collected.

In an embodiment, during implementation of storing the conversion efficiency into the queue with the preset capacity based on the collection sequence, the processor 301 is configured to implement steps of:
performing a dequeuing operation on the head data of the queue when the queue is full, and storing currently collected conversion efficiency in the queue as the tail data; and
storing the currently collected conversion efficiency in the queue as the tail data when the queue is not full.

An embodiment of this application further provides a computer-readable storage medium. The computer-readable storage medium stores a computer program. The computer program includes a program instruction, and the processor executes the program instruction to implement any protection method for a power conversion circuit according to the embodiments of this application.

The computer-readable storage medium may be an internal storage unit of the computer device in the foregoing embodiment, for example, a hard disk or internal memory of the computer device. The computer-readable storage medium may also be an external storage device of the computer device, for example, a plug-in hard disk, a smart media card (SMC), a secure digital (SD) card, and a flash card equipped on the computer device.

The foregoing descriptions are merely specific implementations of this application, but the protection scope of this application is not limited thereto. Various equivalent modifications or substitutions can be readily figured out by a person skilled in the art within the technical scope disclosed in this application, and these modifications or substitutions shall fall within the protection scope of this application. Therefore, the protection scope of this application shall be subject to the protection scope of the claims.

## Claims

1. A protection method for a power conversion circuit, comprising:
calculating an attenuation amount of conversion efficiency of the power conversion circuit within a preset duration when the power conversion circuit is in a steady state;
monitoring the attenuation amount based on a preset attenuation threshold, and obtaining a duration for which the attenuation amount is greater than the preset attenuation threshold; and
performing a preset protection operation when the duration is greater than a preset protection duration.

2. The protection method for a power conversion circuit according to claim 1, wherein before the calculating an attenuation amount of conversion efficiency of the power conversion circuit within a preset duration when the power conversion circuit is in a steady state, the method further comprising:
calculating current conversion efficiency of the power conversion circuit based on an input power and an output power of the power conversion circuit;
calculating a real-time efficiency deviation based on historical conversion efficiency and the current conversion efficiency, wherein the historical conversion efficiency is conversion efficiency detected last time;
monitoring the real-time efficiency deviation based on a preset deviation threshold, and obtaining a first duration for which the real-time efficiency deviation is less than the preset deviation threshold; and
determining that the power conversion circuit is in the steady state when the first duration reaches a preset steady-state duration.

3. The protection method for a power conversion circuit according to claim 2, wherein the monitoring the real-time efficiency deviation based on a preset deviation threshold, and obtaining a first duration for which the real-time efficiency deviation is less than the preset deviation threshold comprise:
monitoring the real-time efficiency deviation;
accumulating the first duration if it is monitored that the real-time efficiency deviation is less than the preset deviation threshold; and
resetting the first duration if it is monitored that the real-time efficiency deviation is greater than or equal to the preset deviation threshold.

4. The protection method for a power conversion circuit according to claim 2, wherein after the obtaining a first duration for which the real-time efficiency deviation is less than the preset deviation threshold, the method further comprising:
determining that the power conversion circuit is in an unsteady state when the first duration does not reach a preset steady-state duration.

5. The protection method for a power conversion circuit according to claim 1, wherein the calculating an attenuation amount of conversion efficiency of the power conversion circuit within a preset duration when the power conversion circuit is in a steady state comprises:
calculating a difference between current conversion efficiency of the power conversion circuit and conversion efficiency before the preset duration, to obtain the attenuation amount.

6. The protection method for a power conversion circuit according to claim 1, wherein:
when a duration for which the power conversion circuit is in the steady state is less than a target duration threshold, the preset duration is the duration for which the power conversion circuit is in the steady state; and
when the duration for which the power conversion circuit is in the steady state is greater than or equal to the target duration threshold, the preset duration is the target duration threshold.

7. The protection method for a power conversion circuit according to claim 1, wherein the calculating an attenuation amount of conversion efficiency of the power conversion circuit within a preset duration when the power conversion circuit is in a steady state comprises:
collecting the conversion efficiency of the power conversion circuit based on a preset collection interval when the power conversion circuit enters the steady state;
storing the conversion efficiency into a queue with a preset capacity based on a collection sequence; and
calculating a difference between head data and tail data of the queue to obtain the attenuation amount, wherein the preset duration is a duration between a time when the head data is collected and a time when the tail data is collected.

8. The protection method for a power conversion circuit according to claim 7, wherein the storing the conversion efficiency into a queue with a preset capacity based on a collection sequence comprises:
performing a dequeuing operation on the head data of the queue when the queue is full, and storing currently collected conversion efficiency in the queue as the tail data; and
storing the currently collected conversion efficiency in the queue as the tail data when the queue is not full.

9. A power conversion apparatus, comprising a power conversion circuit and one or more controller, wherein the controller is configured to implement the steps of the protection method for a power conversion circuit according to any of claims 1 to 8.

10. A computer-readable storage medium, storing a computer program, wherein the computer program, when being executed by a processor, causes the processor to implement the steps of the protection method for a power conversion circuit according to any of claims 1 to 8.
